**Europäisches Patentamt**

**European Patent Office**

**Office européen des brevets**

(11) Publication number: **0 310 245**

**A2**

## (12) EUROPEAN PATENT APPLICATION

(21) Application number: **88308078.0**

(22) Date of filing: **01.09.88**

(51) Int. Cl.4: **H01L 39/24 , C23C 18/02 , H01L 39/12**

(30) Priority: **30.09.87 US 103245**
**22.12.87 US 136270**
**27.04.88 US 186627**

(43) Date of publication of application:
**05.04.89 Bulletin 89/14**

(84) Designated Contracting States:
**DE FR GB**

(71) Applicant: **GENERAL MOTORS CORPORATION**
**General Motors Building 3044 West Grand Boulevard**
**Detroit Michigan 48202(US)**

(72) Inventor: **Micheli, Adolph Louis**
**38900 Elmite**
**Mt. Clemens Michigan 48045(US)**
Inventor: **Mantese, Joseph Vito**
**61331 Windwood Ct.**
**Washington Michigan 48094(US)**
Inventor: **Dungan, Dennis Forest**
**38431 Asbury Park**
**Mt. Clemens Michigan 48043(US)**
Inventor: **Hamdi, Aboud Halal**
**3988 Dorothy Street**
**Detroit Michigan 48211(US)**
Inventor: **Laugal, Ruth Carol Olsen**
**8105 Rene Ct.**
**Union Lake Michigan 48085(US)**

(74) Representative: **Haines, Arthur Donald et al**
**Patent Section (F6) Vauxhall Motors Limited**
**P.O. Box 3 Kimpton Road**
**Luton, Beds. LU2 OSY(GB)**

(54) **Formation of film superconductors by metallo-organic deposition.**

(57) Superconducting thin films of $RE_1Ba_2Cu_4O_z$, where RE is a rare earth metal chosen from the group consisting of yttrium, ytterbium, and europium, are produced in a non-vacuum environment using metallo-organic deposition techniques. A metallo-organic solution comprising the neodecanoates of the rare earth metal, barium, and copper is formed and spun on a single crystal substrate of strontium titanate to form a film thereon. The metallo-organic film is heated in an air environment at a temperature sufficient to decompose the neodecanoates, about 500°C, and then annealed to promote recrystallization and grain growth of the resulting metal oxides. The annealing step is preferably accomplished using rapid thermal annealing techniques wherein the material is uniformly and rapidly heated to an appropriate temperature for an amount of time of up to about 2 minutes. The resulting films of material exhibit superconductive characteristics at elevated temperatures relative to the temperature of liquid nitrogen.

## FORMATION OF FILM SUPERCONDUCTORS BY METALLO-ORGANIC DEPOSITION

This invention relates to superconductive materials and methods for making films of superconductive materials as specified in the preamble of claim 1, for example as disclosed in the article entitled "Preparation of Y-Ba-Cu oxide superconductor thin films using pulsed laser evaporation from high $T_c$ bulk material" by Dijkkamp et al, Appl. Phys. Lett. 51 (8), 24 August 1987.

### Background of the Invention

A wide variety of superconductive materials having high transition temperatures have been reported, including superconducting materials comprising yttrium, barium, and copper. The discovery of these and other compounds which are characterized by superconductive properties above the temperature of liquid nitrogen, has prompted intensive efforts aimed at the development of thin films from these materials. Thin film superconductors based upon these yttrium, barium, and copper compounds have been prepared by electron-beam and sputter deposition, laser ablation of the material from bulk samples, and multi-layer depositions of the constituent elements followed by annealing. These are all processes which require vacuum processing.

As new materials with ever increasing superconductive transition temperatures are sought and developed, it is desirable to have a means for preparing thin films of these superconducting materials which utilizes non-vacuum techniques, permits easy alteration of chemical components, and is compatible with other film processing techniques.

### Summary of the Invention

A method for producing films of superconductor materials according to the present invention is characterised by the features specified in the characterising portion of claim 1.

It is an object of the present invention to provide superconductive films of material, in particular superconductive films characterized by superconducting transition temperatures greater than the liquid nitrogen temperature.

It is a further object of this invention to provide a method for forming films of superconductive materials.

It is still a further object of this invention that these superconductive films be formed in a non-vacuum, oxygen-containing environment.

In accordance with a preferred embodiment of this invention, these and other objects and advantages are accomplished as follows.

For the first time thin film superconductors have been prepared in a non-vacuum, oxygen-containing environment using Metallo-Organic Deposition (MOD) techniques. Metallo-organic deposition is an entirely non-vacuum method of film deposition. A metallo-organic compound is a compound formed between a metal element and an organic radical, such as, for example, barium neodecanoate. A liquid solution of metallo-organic compounds is prepared by dissolution of the metallo-organic compounds in a suitable solvent. This solution is then applied much in the same manner as photo-resist material, i.e, by spin-coating the metallo-organic solution onto a selected substrate material. The soft metallo-organic film is then heated in air or oxygen to decompose the organic components, so that a thin film is formed from the remaining metal oxides. Subsequent heat treatment of the metal oxide film results in a superconductive film of material.

By utilizing non-vacuum processing techniques, the metallo-organic deposition method provides a practical means for film preparation of semi-conductor materials. In addition, the ease with which compounds of a variety of elements can be made allows a wide range of multi-metal compounds to be prepared.

Superconducting thin films, comprising barium, copper, and a rare earth (RE) metal, were formed on single crystal strontium titanate substrates by the thermal decomposition of a solution of the neodecanoates of the barium, copper, and rare earth metal. The preferred rare earth metals include yttrium, ytterbium, and europium.

As an illustrative example, $YBa_2Cu_4O_z$ superconducting films are formed in the following manner. A solution preferentially combines about 1 gram of the combined metal neodecanoates to about 1 millilitre of solvent, e.g., about 100 grams of the metal neodecanoates (about 13.5 grams of the yttrium neodecanoate, about 40.0 grams of the barium neodecanoate, and about 46.5 grams of the copper neodecanoate) were combined with about 100 millilitres of solvent (about five to twenty-five volume percent of pyridine in xylene). The strontium titanate substrate was flooded with a solution of the preferred composition, and then spun dry at about 2000 revolutions per minute for about 30 seconds. The substrates were then rapidly placed in an air oven, which was pre-heated to about 500°C, for about five minutes so as to pyrolize the metallo-organic compounds to their oxides. During this pyrolysis step, the metal neodecanoates are decomposed so that only a film comprising the desired metal oxide constituents remains on the substrate surface.

The metal oxide film was subsequently rapidly thermally annealed in flowing oxygen in a two-step process. The films were annealed at about 850° C for about 60 seconds, then immediately cooled to room temperature. A second rapid annealing was performed at about 920° C for about 30 seconds followed by a rapid cooling to room temperature. Rapid thermal annealing of the films after pyrolysis resulted in superconductive films characterized by sharp transitions to full superconductivity.

Rutherford Backscattering Spectrometry was used to determine that the empirical composition of the resulting film prepared in accordance with this method was approximately $YBa_2Cu_4O_z$. It is believed that the value of z ranges between about 6 to about 8, as this is the ratio of the metals which corresponds to superconducting properties. This method of preparation may be employed to produce superconducting films of the rare earth (RE) metals having a general empirical composition of approximately $REBa_2Cu_4O_z$, wherein the rare earth metal is chosen from the group consisting of yttrium, ytterbium, europium, or a yttrium/europium combination.

Electrical measurements show a zero state resistance temperature of about 86K for a Y-Ba-Cu superconducting film prepared in accordance with this method and a superconducting transition temperature of about 90K. A superconducting film prepared in accordance with this method, comprising ytterbium and having an approximate empirical composition $YbBa_2Cu_4O_z$, is also characterized by a zero state resistance temperature of about 86K and a superconducting transition temperature of about 90K. A superconducting film prepared in accordance with this method, comprising europium and having an approximate empirical composition $EuBa_2Cu_4O_z$, exhibited a zero state resistance temperature of about 20K and a superconducting transition temperature of about 70K.

Suitable superconducting results have also been obtained by conventionally annealing the metal oxide thin films after pyrolysis of the metal neodecanoates. In accordance with this method the thin films are annealed in an oxygen-containing environment for long durations, i.e., about six hours, at about 850° C, and then slowly cooled to room temperature. The superconducting films prepared in accordance with this method are characterized by broad transitions to full superconductivity. Therefore although this method of annealing forms suitable superconducting films, it is a less preferred method. For example, a superconducting film of $YBa_2Cu_4O_z$, prepared in accordance with this less preferred method, is characterized by a superconducting transition temperature of about 90K, with about 27K found to be the temperature of zero state resistance.

This invention comprises the first instance of the employment of non-vacuum techniques to produce thin film superconductors.

Other objects and advantages of this invention will be better appreciated from a detailed description thereof which follows.

Detailed Description of the Invention

The method of this invention produces thin film superconductors using an entirely non-vacuum method. Metallo-organic deposition techniques are utilized to prepare the thin films of superconductive materials. Metallo-organic deposition is a highly reproducible method of thin film deposition which does not require a vacuum, produces films of uniform composition and thickness, and permits a simple but very controlled method for altering the chemical constituents of the films. Using rapid thermal annealing techniques the films prepared in accordance with these metallo-organic deposition techniques are characterized by sharp transitions to full superconductivity.

In the present invention, metallo-organic solutions are prepared using carboxylates of a rare earth (RE) metal, barium, and copper. The preferred carboxylates for forming the metallo-organic solutions are the neodecanoates of the various metals. It has been found that the neodecanoates tend to be more soluble in the xylene/pyridine solution than other carboxylates, such as the 2-ethyl-hexanoates, and therefore result in the production of superior films. The preferred rare earth metals are yttrium, ytterbium, europium, erbium and neodymium. Rutherford Backscattering Spectrometry analysis was used to determine film composition and thickness. Using this technique, the composition of the metallo-organic solutions may be adjusted to obtain the desired superconducting compositions.

Rutherford Backscattering Spectrometry analysis revealed that the relative metal compositions of the preferred thin films were approximately $REBa_2Cu_4O_z$, where the rare earth (RE) metal comprises yttrium, ytterbium, europium, a ytterbium/europium combination, erbium or neodymium. Using Rutherford Backscattering Spectrometry, the relative compositions for the ytterbium-comprising films and the europium-comprising films were not determined precisely, because the relatively heavy atomic weight of ytterbium and europium prevented the accurate detection of these metals since the heavy metals were not entirely distinguishable from the barium in the composition. In addition, the concentration of oxygen in the thin films could not be determined precisely from the Rutherford Backscattering Spectrometry spectrum because the oxygen signal from the thin film coatings overlapped with that of the substrate on which the thin film coatings were formed.

The usual solvent for the metal neodecanoates is xylene, however it was observed that the yttrium, ytterbium, and europium neodecanoates gel in xylene forming an unusable ink. It was found that the addition of approximately about 5 to about 25 percent pyridine by volume to the xylene forms a solvent that will not gel these neodecanoates, although as low as about 1 percent pyridine should produce suitable films. However, far superior films are obtained with the increased amounts of pyridine specified above.

It is to be noted that, although the pyridine is necessary, since without the pyridine the rare earth metal neodecanoate gels in xylene, it is desirable to minimize the amount of pyridine present. Xylene promotes good film formation with its excellent surface wetting characteristics, therefore it is desirable to maximize the amount of xylene present. It was found that the addition of five volume percent pyridine in the xylene broke the gel, yet did not totally dissolve the rare earth metal neodecanoate. In a solution having about 18 percent pyridine in xylene, yttrium neodecanoate is almost totally dissolved, however evidence of the gel material still remains. In a 23 volume percent pyridine in xylene solution, yttrium neodecanoate is completely dissolved, resulting in a superb metallo-organic solution. The resulting thin films produced with this solution are superb in quality. Therefore the optimal range appears to be about 20 to 25 volume percent pyridine in the xylene.

It also appears to be necessary for producing high quality films that the neodecanoates remain in solution for many hours. Typically the neodecanoates are dissolved into solution and stirred continuously for a length of time. It was found that the metallo-organic solution which was stirred for only 16 hours produced lesser quality films, while the metallo-organic solution which was stirred continuously for 60 hours produced films of extraordinary quality, exhibiting no evidence of surface defects over large areas of the substrate. Therefore, it is preferable that the solution be stirred for a length of time sufficient to intimately mix the constituents of the metallo-organic solution.

An alternative method for forming the metallo-organic solutions comprises adding the pyridine in two steps with a period of time between each addition for continuous stirring. First, the barium, copper, and rare earth neodecanoates are dissolved by stirring the neodecanoates in a 90 to 95 volume percent xylene and 5 to 10 volume percent pyridine solvent for approximately ten hours at room temperature. An additional amount of pyridine, up to about 25 volume percent total, is subsequently added to the metallo-organic solution after the first stirring step and the solution is further stirred for approximately one hour. There does not appear to be any benefits realized with this two step method, although suitable results were obtained. By forming a solution of the metal neodecanoates, the elements which will ultimately form the superconducting compound are most intimately mixed with one another.

The prepared metallo-organic solutions are subsequently spun on smooth strontium titanate substrates and then pyrolized to decompose the neodecanoates within the metallo-organic solution. Prior to pyrolysis, the metallo-organic solution is carefully poured onto the top surface of a stationary strontium titanate substrate, so as to flood the surface of the substrate. The strontium titanate substrates are about one centimetre square by about 0.15 centimetre height, oriented in the < 100 > crystal direction. The viscous metallo-organic solutions are spun onto the substrate surface at various speeds. Any excess solution is spun-off the substrate during spinning.

The following film thicknesses correspond to a viscosity of approximately 0.014 Pas (14 centipoise) for the metallo-organic solution. After 20 seconds at about 2000 revolutions per minute (RPM), the thickness of the metallo-organic film, after drying at about 85°C so as to evaporate any solvent, will be about 4.4 micrometres, and the thickness of the metal oxide film, after heating to about 500°C so as to decompose the neodecanoates, will be about 260 nanometres (2600 Angstroms). For 20 seconds at 3000 RPM, the thickness of the metallo-organic film after drying at 85°C will be about 3.7 micrometres and the thickness of the metal oxide film after heating at about 500°C will be about 210 nanometres (2100 Angstroms). After about 20 seconds at 4000 RPM, the corresponding thicknesses of the respective films after drying at 85°C and heating at 500°C are about 3.1 micrometres and 209 nanometres (2090 Angstroms) respectively. After about 20 seconds at 7000 RPM the corresponding thicknesses of the respective films after drying at 85°C and heating at 500°c are about 2.6 micrometres and 170 nanometres (1700 Angstroms) respectively. These measurements were made using a step profile detector.

The method used during the pyrolysis of the metallo-organic solutions is significant, in that thermogravimetric analysis shows that the metal neodecanoates of the rare earth metal, the copper, and the barium volatilize and decompose at different temperatures to one another. It was determined that the freshly-prepared metallo-organic solutions, which have been spun onto the substrates, should be rapidly placed in a furnace pre-heated to about 500° C. It is preferred that the prepared solutions do not remain at ambient conditions for too long a duration of time, although suitable results have been obtained when the films have remained at room temperature for a substantial duration of time, or even have been dried at an elevated temperature such as 100° C, prior to the pyrolysis.

Using thermogravimetric analysis, it has been determined that the neodecanoates of the metals decompose at different temperatures. By placing the spun-on metallo-organic solutions rapidly into the oven pre-heated to a temperature greater than the decomposition temperature of each of the neodecanoates, the metal neodecanoates decompose simultaneously and instantaneously. This ensures uniform decomposition and results in a higher quality film. Also, it is believed that barium neodecanoate decomposes in two steps, therefore this manner of pyrolysis is desirable to ensure uniform and homogenous decomposition of each of the metallo-organic compounds present. This method results in high quality thin films of the metal oxides which ultimately become the superconducting composition.

After the pyrolysis step an oxide film of the appropriate metal oxide composition remains on the substrate. The proportion of the metals within the oxide composition remaining on the substrate surface does not necessarily correspond to the proportions of the metals initially in the metallo-organic solution. This is due to the differences in volatilities and decomposition rates for the various metal neodecanoates. However, the proportion of the metals within the oxide composition remaining on the substrate after pyrolysis does correspond reliably to the final composition of the superconducting film after annealing. Using this method for film preparation, the composition of the metallo-organic solutions may be adjusted to obtain various compositions in the oxide films.

This two-step sequence of first spinning the metallo-organic solution onto the substrate followed immediately by pyrolysis at a temperature sufficient to decompose the metal neodecanoates, may be repeated a sufficient amount of times, so as to produce oxide films having a thickness of up to about 2.0 micrometres. Suitable results should also be obtained with oxide film thicknesses as low as about 0.1 micrometres. These films may be processed, by employing multiple deposition techniques in accordance with this invention, to result in thicker or thinner films for optimal superconducting characteristics.

After repeating the spinning and pyrolysis sequence sufficiently so as to achieve the desired metal oxide thickness on the substrate, the films are then annealed in a non-vacuum, oxygen-containing environment at atmospheric pressure and a sufficient temperature for a sufficient duration of time to promote re-crystallization and grain growth within the metal oxides. The resulting films are characterized by superconductive electrical properties.

It is preferred that the metal oxide films be rapidly thermally annealed, i.e., exposed to the annealing temperature for a relatively short duration of time, from an instantaneous amount of time up to about 2 minutes. It is also preferred that the rapid thermal annealing be accomplished in two steps: first, a lower temperature exposure which presumably creates small nucleation sites at the substrate/film interface and a second higher temperature exposure to promote rapid grain growth at those nucleation sites. The first exposure at the lower temperature appears to be beneficial since it creates the nucleation sites, yet reduces the amount of diffusion interaction between the substrate and film.

It has been determined that the use of rapid thermal annealing techniques produces superconducting films characterized by higher zero state resistance temperatures and sharp transitions to full superconductivity. This is contrast to the broad transitions to full superconductivity for the films which are conventionally annealed by baking at the desired temperature for a longer duration of time, i.e., about 6 hours.

Rapid thermal annealing techniques raise the temperature of the substrate and deposited film uniformly and almost instantaneously to the desired annealing temperature. Two methods are generally employed for rapid thermal annealing. The first method, which is the preferred method, comprises heating the material using quartz lamps. The quartz lamps generate extremely large dosages of infra-red electromagnetic radiation. The substrates and films are heated very rapidly by exposing the substrates to the electromagnetic radiation generated by the quartz lamps. The second method involves placing the substrates and films on a graphite receptacle and exposing the substrates to microwaves. The microwaves impinge on the films deposited on the surface of the substrate and heat the film and substrate uniformly and quickly.

## Y-Ba-Cu Films

Superconducting films of the approximate empirical composition $YBa_2Cu_4O_z$, were produced using the method of the present invention. A metallo-organic solution was prepared using the neodecanoates of yttrium, barium, and copper. The yttrium and the barium neodecanoates were formed from their metal acetates by reaction with ammonium neodecanoate. The copper neodecanoate was formed by a reaction of copper (II) acetate with tetramethyl ammonium neodecanoate. The usual solvent for the metal neodecanoates is xylene, however it has been observed that the yttrium neodecanoate gels in xylene, forming an unusable ink. The addition of approximately 20 to 25 volume percent pyridine to the xylene forms a solvent that will not gel the yttrium neodecanoate, and results in thin films of superb quality. The metal-neodecanoate solution is optimally stirred for a long period of time, although this is not essential, so as to ensure complete and intimate mixing of the solution constituents. Several solutions containing the yttrium, barium, and copper neodecanoates, in various concentrations, were made by dissolving the three components in appropriate amounts of xylene and pyridine.

The metallo-organic solution which resulted in the superconductor film composition of $YBa_2Cu_4O_z$, had a ratio of one gram of the combined metal neodecanoates to one millilitre of solvent. About 13.5 grams of yttrium neodecanoate, about 40.0 grams of barium neodecanoate, and about 46.5 grams of copper neodecanoate, yielding a total of about 100 grams of metal neodecanoate, were dissolved in about 100 millilitres of solvent, the solvent comprising about 20 to 25 millilitres of pyridine preferably in a balance of xylene. The metallo-organic solution was continuously stirred, preferably for approximately 60 hours, at room temperature. This method results in superior metallo-organic solutions for purposes of forming high-quality superconducting films. However, suitable results have been obtained when the solvent contains less pyridine or has been stirred for a shorter duration of time.

The metal neodecanoates, when dissolved in the solvents, yield a green coloured liquid having an approximate viscosity of approximately 0.014 Pas (14 centipoise), although the viscosity may range between about 0.0005 and 0.015 Pas (5 and 15 centipoise) with no detrimental effects. If the solutions become too viscous, they will not coat the substrate uniformly during the spinning step. If the solutions are not viscous enough they may run off the substrate and again form poor quality films. The solutions were filtered, using Teflon (R.T.M.) membranes, to remove particles down to approximately 200 nanometres in size.

The metallo-organic solutions prepared from the yttrium, barium, and copper neodecanoates and solvents were flooded onto stationary single crystal strontium titanate, $SrTiO_3$, substrates of about one centimetre width by about one centimetre length by about 0.15 centimetre height, oriented in the < 100 > crystal direction. The metallo-organic solutions were spun dry on the substrates at various speeds, about 2000 revolutions per minute for about 20 seconds being preferred. The spun-on solutions were immediately placed in a furnace pre-heated to about 500° C. The spun-on solutions were heated in air at that temperature, 500° C, for about 5 minutes to decompose the yttrium, barium, and copper neodecanoates. This two-step, spin-on and fire, deposition sequence was typically repeated many times to build the thickness of the films up to preferably about 2.0 micrometres in thickness. However multiple depositions of the films are not an essential feature of the invention. X-ray diffraction analysis of the films pyrolized at 500° C showed the presence of only microcrystallites. Room temperature resistivities of $1 \times 10^2$ ohms-centimetre were measured for these films; i.e., no superconducting behavior was observed for these films after pyrolysis.

The method in which the dried metallo-organic solutions are fired on the substrates is important because thermogravimetric analysis shows that the metal neodecanoates volatalize and decompose at different temperatures. Complete decomposition of the combined yttrium, barium, and copper neodecanoates used in this invention occurs at about 450° C, leaving only the yttrium, barium, and copper oxides on the substrate in an amount proportional to the original metallo-organic solutions. It has been found that, if the dried solutions on the substrates are immediately placed in a furnace set at about 500° C, high-quality thin films of the superconducting composition are made. After pyrolysis, the thin films are characterized by very fine crystallites distributed uniformly throughout the film.

After forming the desired thickness of the film and carrying out the subsequent pyrolysis required to decompose the organic neodecanoates and leave only the metal oxides on the substrate, the samples were annealed in a non-vacuum, oxygen-containing environment to promote recrystallization and grain growth within the material. Preferably, the films were rapidly thermally annealed in two steps, at approximately 850° C and approximately 920° C respectively, in an oxygen-containing atmosphere for a period of time up to about 2 minutes, the films being rapidly quenched to room temperature after each exposure at the respective annealing temperature. The resulting films of approximate empirical formula $YBa_2Cu_4O_z$, as determined by Rutherford Backscattering Spectrometry, exhibited superconductive characteristics.

Many Y-Ba-Cu samples were prepared in accordance with this metallo-organic deposition and pyrolysis method, and then rapidly thermally annealed in a stream of flowing oxygen. The strontium substrates having the Y-Ba-Cu films were placed upon oxidized silicon wafers, rapidly heated to about 850°c for about 60 seconds using infrared radiation produced by a bank of quartz lamps, then allowed to cool to room temperature. A second rapid annealing was then performed at 920°C for about 30 seconds.

Thin film superconductors formed in this manner were very uniform in structure and thickness across the surface of the film. Unlike films formed from metallo-organic deposition of the two-ethyl hexanoates or sol-gels, the films formed from the neodecanoates were quite homogeneous with no cracking or large voids being present. The average grain size within the film after rapid thermal annealing was found to be approximately 1 micrometre wide and approximately 2 micrometres long. This is a factor of about 4 times larger than the grain size of conventional furnace-annealed films formed by this metallo-organic deposition method.

A large grain size is an important factor in obtaining high temperature superconducting films with an abrupt transition to zero resistance. The grain size of the superconducting phase $YBa_2Cu_3O_z$, the 1:2:3 phase, increases as the temperature increases up to the melting point of the materials, about 935°C. Therefore, the second annealing temperature of 920°C is beneficial for promoting grain growth within the films.

Rutherford Backscattering Analysis, using 3.6 MeV 4He[+] ions, showed that films formed from the combined neodecanoates had the compositions $YBa_{2.25}Cu_{4.19}O_z$ where z is undetermined. By dissolving the films in nitric acid it was also possible to analyze their chemical composition using Inductively Coupled Plasma Emission Spectroscopy (ICPES). From the ICPES analysis it was determined that the Y-based films had the composition $YBa_{2.18}Cu_{4.10}O$. The two distinct methods of chemical analysis show excellent agreement for the Y-based films.

Four-probe resistance versus temperature measurements were obtained for the films of Y-Ba-Cu which had been processed by rapid thermal annealing in two-steps. A superconducting transition temperature was observed at about 90K with zero resistance at 86K. The critical current density of the rapidly thermally annealed films is approximately 200 Amperes per square centimetre at 77K. Room temperature resistivities of the rapidly thermally annealed samples were about $3\times10^{-3}$ ohmscentimetres.

X-ray diffraction was performed on the Y-Ba-Cu films prepared in accordance with the metallo-organic deposition and rapid thermal annealing methods disclosed hereinbefore. Analysis of the diffraction pattern showed that the $YBa_2Cu_3O_z$ (1:2:3 phase) was the major phase and has an orthorhombic crystal structure. Strong peaks due to the (00 ) diffraction planes of the 1:2:3 phase indicate preferential orientation of the 1:2:3 grains with their c-axis perpendicular to the <100> $SrTiO_3$ surface. There are also other very strong peaks due to the (h00) diffraction planes which indicates that some of the 1:2:3 grains are preferentially oriented with their a-axis perpendicular to the <100> $SrTiO_3$ surface, implying preferential 1:2:3 grain orientation with the c-axis parallel to the substrate surface. The x-ray measurements performed do not permit a quantitative determination of the percentage of grains oriented in either of the two directions. The two major orientations may be due to the presence of a bi-layer structure which results in some rapidly thermally annealed films.

In addition to the pronounced 1:2:3 peaks indicating a preferentially oriented film structure, there are other peaks due to the minor phases of $BaCuO_2$, $Y_2BaCuO_5$ and the gamma phase ($Y_2Ba_4Cu_8O_2$). Unlike the specimens conventionally furnace-annealed at 850°C, a reduced amount of $YBaSrCu_3Ox$ was observed, which indicates the rapid thermal annealing may reduce the interaction between the substrate and the metal oxide film.

Ion-channelling analysis using 2 MeV 4He[+] was also performed on the Y-Ba-Cu film and indicated that there was some epitaxial growth of the film on the <100> $SrTiO_3$ substrate, which confirmed the results of the X-ray diffraction analysis. From the combined x-ray and channelling work, it was observed that the 1:2:3 phase was the major phase in the films and that the grains were preferentially oriented with respect to the <100> $SrTiO_3$ surface.

It is believed that the preferred orientation may arise because the first anneal at 850°C initiates grain growth at nucleation sites at the $SrTiO_3$ surface. The second anneal at 920°C, which is only slightly below the temperature, 935°C, where the high transition temperature Y-Ba-Cu materials melt incongruently, may result in grain growth from the grains formed on the substrate during the first anneal. It appears that the high superconducting onset and zero resistance temperatures of the rapidly thermally annealed materials may be the result of the combined effects of enhanced grain growth and reduced strontium diffusion into the superconducting films.

For a $YBa_2Cu_4O_z$ film, rapidly thermally annealed in a single step at approximately 920°C for about 1 minute and subsequently quenched in air to room temperature, a zero point resistance temperature of about 70K was measured, wherein the upper limit for the resistivity was set at $7.6 \times 10^{-8}$ ohms per centimetre. This material is also characterized by a superconducting transition temperature of about 90K, wherein a rapid drop in resistance was observed. At room temperature the resistivity was approximately $2.7 \times 10^{-3}$ ohms per centimetre. Silver paint was used to make the four probe resistance measurements in order to determine the superconducting characteristics.

It is preferred that the material be annealed at a temperature ranging between about 850°C to about 1000°C and for a duration of time up to about 2 minutes, with a time duration of about 15 seconds to one minute being more preferred. The duration and annealing temperature are inversely related to one another; i.e, a shorter duration is required at a higher temperature.

Although the rapid thermal annealing technique is preferred, superconducting thin films of $YBa_2Cu_4O_z$, with z ranging between about 6-8, were also prepared by annealing at 850°C for 6 hours, rather than rapid thermal annealing. These samples were then slowly cooled to room temperature, at a rate of about 100°C per hour. Resistance versus temperature measurements for these superconducting thin films were then determined. Silver paint was used to make four probe resistance measurements. At room temperature the resistivity was approximately $2.7 \times 10^{-3}$ ohms per centimetre. A rapid drop in resistance was observed around 90K with zero resistance achieved at 37K. An upper limit for the resistivity at 37K was set at $7.6 \times 10^{-8}$ ohms per centimetre, representing a decrease from the room temperature resistivity by a factor of 36,000.

Superconducting thin films of $YBa_{3.3}Cu_{5.7}O_z$ were also formed on strontium titanate substrates oriented in the <112> crystal direction by metallo-organic deposition techniques in accordance with this invention, and subsequent annealing at about 850°C for about 6 hours followed by slow cooling to room temperature at about a rate of 100°C per hour. Silver paint was used to make four probe resistance measurements and a superconducting transition temperature of about 80K was observed with about 27K found to be the temperature of zero state resistance for this material.

Superconducting thin films of $YBa_2Cu_3O_z$ were also formed in accordance with this invention on strontium titanate substrates oriented in the <112> direction. However, a significantly lower superconducting transition temperature for the $YBa_2Cu_3O_z$ films, about 17K, was observed. Scanning electron micrographs show that the average grain size of the $YBa_2Cu_3O_z$ films is about half as large, about 125 nanometres, as those of the $YBa_2Cu_4O_z$ or $YBa_{3.3}Cu_{5.7}O_z$ films. This substantial difference in grain size may account for the difference in values of superconducting transition temperatures. It is believed that rapid thermal annealing techniques would enhance the superconducting properties of these materials.

Yb-Ba-Cu Films

Superconducting films comprising the rare earth metal, ytterbium, and having an empirical composition of $YbBa_2Cu_4O_z$, were produced using this metallo-organic deposition method. A metallo-organic solution was prepared using the neodecanoates of ytterbium, barium, and copper. The ytterbium and the barium neodecanoates were formed from their metal acetates by reaction with ammonium neodecanoate. The copper neodecanoate was formed by a reaction of copper (II) acetate with tetramethyl ammonium neodecanoate. The metal neodecanoates were prepared in the same manner as the yttrium-based materials. Solutions containing the ytterbium, barium, and copper neodecanoates, in various concentrations, may be made by dissolving the three components in appropriate amounts of xylene and pyridine.

The ytterbium-containing solution which resulted in the superconductor film composition of $YbBa_2Cu_4O_z$, had a ratio of one gram of the combined metal neodecanoates to one millilitre of solvent. Approximately 15.5 grams of the ytterbium neodecanoate, 39.0 grams of the barium neodecanoate, and 45.5 grams of the copper neodecanoate, yielding a total of about 100 grams of metal neodecanoate, were dissolved in about 100 millilitres of solvent, the solvent comprising about 80 millilitres of xylene with about 20 millilitres of pyridine.

The metallo-organic solution was sufficiently stirred so as to ensure intimate mixing of the components thereof. The solutions were viscous and were filtered, using Teflon (R.T.M.) membranes, to remove particles down to approximately 200 nanometres in size.

The metallo-organic solutions prepared from the ytterbium, barium, and copper neodecanoates and solvents were flooded onto stationary single crystal strontium titanate, $SrTiO_3$, substrates of about one centimetre width by about one centimetre length by about 0.15 centimetre height, oriented in the <100> crystal direction. The solutions were spun dry on the substrates at various speeds, about 2000 revolutions per minute for about 20 seconds being preferred. The spun-on solutions were immediately placed in a furnace pre-heated to about 500°C. The thin film solutions were heated in air at that temperature, 500°C, for about 5 minutes to decompose the ytterbium, barium, and copper neodecanoates leaving the metal oxides on the substrate surface in an amount proportional to the amount within the original metallo-organic solutions. This two-step, spin-on and fire, deposition sequence was typically repeated many times to obtain a desired film thickness between about 1.5 and 2.0 micrometres, however multiple film depositions are not a required feature of the present invention.

Thermogravimetric analysis shows that the metal neodecanoates volatalize and decompose at different temperatures. Complete decomposition of the combined ytterbium, barium, and copper neodecanoates used in this invention occurs at about 450°C, leaving only the ytterbium, barium, and copper oxides remaining on the strontium titanate substrate. It has been found that, if the dried solutions on the substrates are immediately placed in a furnace set at about 500°C, high-quality thin films of the superconducting composition are made. After pyrolysis, the thin films are characterized by uniformly-distributed fine crystallites.

After obtaining the desired thickness of the film and completing the subsequent firing required to decompose the metal neodecanoates and leave only the metal oxides remaining on the substrate, the samples were annealed in a non-vacuum, pure oxygen environment to promote recrystallization and grain growth within the material. Preferably, the films were rapidly thermally annealed in two steps, firstly at about 850°C and cooled, then secondly at about 920°C in an oxygen-containing atmosphere for an amount of time up to about 2 minutes, followed by rapid quenching to room temperature. The resulting films of $YbBa_2Cu_4O_z$, prepared in accordance with this method, exhibited superconductive characteristics.

A ytterbium-containing film having the approximate empirical composition $YbBa_2Cu_4O_z$, as determined by Rutherford Backscattering Spectrometry, was prepared in accordance with the above described metallo-organic deposition method and rapidly thermally annealed in oxygen at atmospheric pressure, first at a temperature of about 850°C for about 60 seconds and subsequently at a second temperature of about 920°C for about 30 seconds. After rapid thermal annealing, the samples are quenched in flowing oxygen to room temperature. The oxygen is flowed at a rate of approximately 4.9 litres/minute.

Silver paint was used to make four probe resistance measurements and a zero point resistance temperature of about 84K was measured for the film. Zero point resistance was defined as that temperature which corresponds to the upper limit for resistivity set at $7.6 \times 10^{-8}$ ohms per centimetre. This material is further characterized by a superconducting transition temperature of at least 90K. At room temperature the resistivity was approximately $1.2 \times 10^{-3}$ ohms per centimetre. X-ray analysis revealed that the superconducting grains within the films were partially epitaxial; a significant portion of the grains having the c-axis perpendicular to the <100> strontium titanate substrate, an orientation which enhances the current-carrying capacity of the films and a significant amount of the remaining portion of the grains having the c-axis parallel to the <100> strontium titanate substrate.

It is believed that this two-step rapid thermal annealing process may be beneficial in that the first lower temperature exposure may promote nucleation within the material at the substrate-film interface, while the second higher temperature exposure facilitates rapid grain growth, by promoting incongruent melting, within the composition. It is generally known that the presence of the liquid phase greatly enhances grain growth within ceramic materials.

However, a single rapid thermal annealing step at 920°C for a short amount of time up to about 2 minutes is believed to be sufficient to produce superconducting films. It is preferred that the material be annealed at a temperature ranging between about 850°C to about 1000°C and for a duration of time up to about 2 minutes, with a duration period about 15 seconds to one minute being especially preferred. The duration and annealing temperature are inversely related to one another; i.e, a shorter duration is required at a higher temperature. In addition, suitable results should be obtained using more conventional annealing techniques such as annealing at about 850°C to about 1000°C for a sufficient time to promote recrystallization and grain growth.

Eu-Ba-Cu Films

Superconducting films comprising the rare earth metal, europium, and having an empirical composition of approximately $EuBa_2Cu_4O_z$, were also produced using this metallo-organic deposition method. A metallo-organic solution was prepared using the neodecanoates of europium, barium, and copper. The europium and the barium neodecanoates were formed from their metal acetates by reaction with ammonium neodecanoate. The copper neodecanoate was formed by a reaction of copper (II) acetate with tetramethyl ammonium neodecanoate. The metallo-organic solutions were prepared in accordance with the methods described above for the Y-Ba-Cu and Yb-Ba-Cu films. With this method, the solutions containing the europium, barium, and copper neodecanoates, of various concentrations, may be made by dissolving the three components in appropriate amounts of xylene and pyridine.

The europium-containing solution which resulted in the superconductor film composition of approximately $EuBa_2Cu_4O_z$, had a ratio of about one gram of the combined metal neodecanoates to about one millilitre of solvent. Approximately 15.5 grams of the europium neodecanoate, 38.6 grams of the barium neodecanoate, and 45.9 grams of the copper neodecanoate, yielding a total of about 100 grams of metal neodecanoate, were dissolved in about 100 millilitres of solvent, the solvent comprising about 80 millilitres of xylene with about 20 millilitres of pyridine. The solution was stirred sufficiently so as to achieve homogeneity within the metallo-organic solution. The solutions were filtered, using Teflon (R.T.M.) membranes, to remove particles down to approximately 200 nanometres in size.

The metallo-organic solutions prepared from the europium, barium, and copper neodecanoates and solvents were flooded onto stationary single crystal strontium titanate, $SrTiO_3$, substrates of about one centimetre width by about one centimetre length by about 0.15 centimetre height, oriented in the <100> crystal direction. The solutions were spun dry on the substrates at various speeds, about 2000 revolutions per minute for about 20 seconds being preferred, and resulting in a film thickness of about 260 nanometres (2600 Angstroms). The spun-on solutions were immediately placed in a furnace pre-heated to about 500°C. The thin film solution were heated in air at that temperature, 500°C, for about 5 minutes to decompose the europium, barium, and copper neodecanoates. This two-step, spin-on and pyrolysis, deposition sequence was typically repeated many times to obtain a desired film thickness between about 1.5 and 2.0 micrometres, however multiple depositions of the film are not a required feature of the present invention.

Thermogravimetric analysis shows that complete decomposition of the combined europium, barium, and copper neodecanoates used in this invention occurs at about 450°C, leaving only the europium, barium, and copper oxides remaining on the strontium titanate substrate in amounts corresponding to the original amounts within the metallo-organic solution. It has been found that, if the dried solutions on the substrates are immediately placed in a furnace set at about 500°C, high-quality thin films of the superconducting composition are made for purposes of preparing superconducting films.

After obtaining the desired thickness of the solution and completing the subsequent firing required to decompose the metal neodecanoates and leave only the metal oxides remaining on the substrate, the europium-containing samples were annealed in a non-vacuum, oxygen-containing environment at atmospheric pressure to promote recrystallization and grain growth within the material. Preferably, the films were rapidly thermally annealed using quartz lamps at about 930°C in an oxygen-containing atmosphere for a short amount of time up to about 2 minutes, and then rapidly quenched to room temperature. The resulting films of $EuBa_2Cu_4O_z$, prepared in accordance with this method exhibited superconductive characteristics.

For a $EuBa_2Cu_4O_z$ sample prepared in accordance with this metallo-organic deposition method and rapidly thermally annealed in oxygen at a temperature of about 930°C for about 45 seconds and quenched in oxygen flowed at a rate of about 4.9 litres per minute to room temperature, a zero point resistance temperature of about 20K was measured, where zero point resistance was defined as the temperature corresponding to a resistivity of $7.6 \times 10^{-8}$ ohms per centimetre. This material is further characterized by a superconducting transition temperature of about 70K, wherein a rapid drop in resistivity occurred. The room temperature resistivity was approximately $2.7 \times 10^{-3}$ ohms per centimetre. Silver paint was used to make the four probe resistance measurements.

It is believed that the empirical composition for the superconducting europium-containing films is approximately $EuBa_2Cu_4O_z$. Rutherford Backscattering Analysis was employed to determine the empirical composition, however due to the weight of the europium, it was difficult to distinguish the europium from the barium during the analysis. This also occurred during the analysis of the ytterbium-containing superconducting material. It is believed that the superconducting characteristics of the europium-containing film may be optimized upon better analysis of the material.

It is preferred that the material be annealed at a temperature ranging between about 850°C to about 1000°C and for a duration of time up to about 2 minutes, with a duration of about 15 seconds to one minute being especially preferred. The duration and annealing temperature are inversely related to one another; i.e. a shorter duration is required at a higher temperature. In addition, suitable results should be obtained using more conventional annealing techniques such as annealing at about 850°C to about 1000°C for a sufficient time to promote recrystallization and grain growth.

## Eu-Yb-Ba-Cu Films

It is further believed that superconducting films comprising both europium and ytterbium having an empirical composition of $Eu_{0.5}Yb_{0.5}Ba_2Cu_4O_z$, may also be produced in accordance with this method for metallo-organic deposition and rapid thermal annealing. A metallo-organic solution comprising the appropriate amounts of the metal neodecanoates of europium, ytterbium, barium, and copper dissolved in the appropriate amounts of pyridine in xylene, would be spun-on to the appropriate substrate and fired at a temperature so as to decompose the organic deodecanotes. The substrate and film would then be annealed, preferably using rapid thermal annealing techniques, at the appropriate temperature to promote grain growth and recrystallization.

## Er-Ba-Cu Films

Superconducting films comprising the rare earth metal, erbium, and having an empirical composition of approximately $ErBa_2Cu_4O_z$, were also produced using this metallo-organic deposition method, as described above for the Y-Ba-Cu, Yb-Ba-Cu and Eu-Ba-Cu films. The erbium-containing solution which resulted in the superconductor film composition of approximately $ErBa_2Cu_4O_z$, has a ratio of approximately one gram of the combined metal neodecanoates to about one millilitre of solvent. Approximately 18.8 grams of the erbium neodecanoate, 37.6 grams of the barium neodecanoate, and 43.6 grams of the copper neodecanoate, yielding a total of about 100 grams of metal neodecanoate, were dissolved in about 100 millilitres of solvent, the solvent comprising about 80 millilitres of xylene with about 20 millilitres of pyridine. The solution was stirred sufficiently so as to achieve homogeneity within the metallo-organic solution. The solutions were filtered, using Teflon (R.T.M.) membranes, to remove particles down to approximately 200 nanometres in size.

The erbium-containing metallo-organic solution was then flooded onto stationary single crystal strontium titanate substrates oriented in the <100> crystal direction, and spun dry at about 2000 revolutions per minute for about 20 seconds. This resulted in a film thickness of about 260 nanometres (2600 Angstroms). The spun-on films were then rapidly placed in a furnace pre-heated to about 500°C for about five minutes to ensure complete and uniform decomposition of the neodecanoates. Thicker films may be produced by repeating the spinning and pyrolysis steps.

The erbium-containing films were then rapidly thermally annealed at about 930°C in an oxygen-containing environment for about 2 minutes and rapidly quenched in flowing oxygen to room temperature. The resultant film of $ErBa_2Cu_4O_z$ exhibited superconductive properties and was characterized by a zero resistance temperature of about 81K, where zero point resistance was defined as the temperature corresponding to a resistivity of $7.6 \times 10^{-8}$ ohms per centimetre.

## Nd-Ba-Cu Films

It is believed that superconductive thin films of a neodymium-barium-copper oxide composition can be prepared using this metallo-organic deposition method. A thin film having the approximate composition of $NdBa_2Cu_4O_z$ was prepared in accordance with this invention and exhibited evidence of superconductivity. The metallo-organic solution was prepared having a ratio of about 1 gram of the metal neodecanoates to about l millilitre of solvent. About 100 grams of the metal neodecanoates; i.e., about 18.8 grams of the neodymium neodecanoate, about 37.6 grams of the barium neodecanoate and about 43.6 grams of the copper neodecanoate, were sufficiently mixed with about 100 millilitres of xylene. Some evidence of gelling within the solution was observed, therefore it may be desirable to add a small amount of pyridine to the solution.

The metallo-organic solution was then spun-on and pyrolyzed at about 500°C in accordance with the deposition process described above with respect to the yttrium, ytterbium, europium, and erbium-containing films. The resultant metal oxide film was then rapidly thermally annealed in an oxygen containing environment at a first temperature of about 850°C for about 60 seconds and quenched to room temperature in flowing oxygen, and subsequently rapidly thermally annealed at about 920°C for about 30 seconds, followed by a second quench in flowing oxygen. The resultant film showed evidence of superconductivity, but not full superconductivity. It is believed that rapid thermal annealing at a higher temperature, such as about 930°C would result in an neodymium-barium-copper oxide film exhibiting full superconductive properties.

With this invention, superconducting thin films of various compositions comprising a rare earth metal have also been formed on barium titanate and sapphire substrates. Other suitable substrates which are temperature and diffusion resistant may be utilized.

This invention readily facilitates modification of the metal constituents and their ratios in the thin films, to obtain optimal superconducting characteristics within the thin films. This invention is also an entirely non-vacuum process which is compatible with film processing techniques.

## Claims

1. A method of producing films of superconductor materials by the deposition of a film of a metal oxide mixture on a substrate followed by the annealing of said film in an oxygen atmosphere to form an oxide mixture exhibiting superconductive properties, characterised in that the method comprises the steps of: forming a solution from a mixture of the neodecanoates of the metals present in said metal oxide mixture; depositing a film of said solution onto said substrate; heating said solution film in an oxygen-containing environment at a first temperature for a period of time that is (a) sufficient to thermally decompose said metal neodecanoates into said film containing the metal oxide mixture, and (b) insufficient to significantly recrystallize said oxides in said metal oxide mixture; and annealing said oxide film at a second temperature for a period of time that is sufficient to promote grain growth of said metal oxides within said oxide film and to induce a change therein by which said oxide film exhibits superconducting properties at a significantly increased temperature above the temperature of liquid nitrogen.

2. A method of producing films of superconductor materials according to claim 1, characterised in that said substrate is selected from the group consisting of strontium titanate, barium titanate, and sapphire.

3. A method of producing films of superconductor materials according to claim 1, characterised in that said first heating step is carried out at a temperature greater than 450°C but less than 850°C.

4. A method of producing films of superconductor materials according to claim 1, characterised in that said annealing step comprises heating said oxide film in said oxygen-containing environment at a temperature greater than said first heating temperature, said greater heating temperature being sufficient to promote said grain growth of said metal oxides within said oxide film.

5. A method of producing films of superconductor materials according to claim 1, characterised in that the temperature of the annealing step lies in the temperature range of 850°C to 1000°C.

6. A method of producing films of superconductor materials according to claim 1, characterised in that said annealing step is a rapid thermal annealing step in which the oxide film is exposed to said second temperature for a period of time that is less than 2 minutes, and the oxide film is then rapidly cooled to ambient temperature at the end of said period of time.

7. A method of producing films of superconductor materials according to claim 1, characterised in that said annealing step comprises a two-stage rapid thermal annealing process in which said oxide film is heated to a first annealing temperature for a brief period of time sufficient to create nucleation sites in the oxide film; said oxide film is rapidly cooled to ambient temperature; said oxide film is then reheated to a second, higher annealing temperature for a brief period of time sufficient to promote rapid grain growth of said metal oxides at said nucleation sites; and then said oxide film is rapidly cooled to ambient temperature, the total period of time that the oxide film is exposed to said first annealing temperature and to said second annealing temperature being up to about 2 minutes.

8. A method of producing films of superconductor materials according to claim 7, characterised in that said first annealing temperature is 850°C and said second annealing temperature is 920°C.

9. A film of superconductor material produced by a method according to any one of the preceding claims.

10. A method of producing thin film superconductor materials according to any one of the preceding claims 1 to 8, characterised in that the solution is formed from the neodecanoates of yttrium, barium, and copper; and said film is heated in said oxygen-containing environment at about 500°C for about 5 minutes, so as to decompose said neodecanoates of yttrium, barium, and copper into said metal oxide film, containing oxides of yttrium, barium, and copper.

11. A thin film of superconductor material produced by a method according to claim 10.

12. A method of producing thin film superconductor materials according to claim 10, characterised in that said resulting superconductive metal oxide film has a thickness ranging between about 0.1 micrometres to about 2.0 micrometres.

13. A method of producing films of superconductor materials according to claim 1, characterised in that the solution of metal neodecanoates comprises: yttrium neodecanoate; barium neodecanoate; copper neodecanoate; and a solvent comprising xylene and about one to about twenty-five volume percent pyridine.

14. A method of producing films of superconductor materials according to claim 13, characterised in that the solution of metal neodecanoates comprises in proportional amounts: about 13.5 grams of yttrium neodecanoate; about 40.0 grams of barium neodecanoate; about 46.5 grams of copper neodecanoate; and about 100 millilitres of said solvent comprising xylene and about one to about twenty-five volume percent pyridine.

15. A metal oxide superconducting film comprising yttrium, barium, and copper produced by any one of claims 10, 12, 13 or 14, characterised in that the molar ratio of yttrium to barium to copper in the film is approximately 1:2:4, respectively.

16. A metal oxide superconducting film comprising yttrium, barium, and copper produced by any one of claims 10, 12 or 13, characterised in that the molar ratio of yttrium to barium to copper is approximately 1:3.3:5.7, respectively.

17. A metal oxide superconducting film comprising yttrium, barium, and copper produced by any one of claims 10, 12 or 13, characterised in that the molar ratio of yttrium to barium to copper is approximately 1:2:3, respectively.

18. A method of producing films of superconductor materials according to claim 1, characterised in that the method includes forming said solution from the neodecanoates of yttrium, barium, and copper, and a solvent, said solvent consisting of xylene and about one to about twenty-five volume percent pyridine; flooding said substrate with said solution, said substrate being selected from the group consisting of strontium titanate, barium titanate, and sapphire; and spin-coating said substrate with said solution at about 2000 revolutions per minute for about 20 seconds.

19. A method of producing films of superconductor materials according to claim 1, characterised in that said solution of metal neodecanoates contains a barium neodecanoate, a copper neodecanoate, and a rare earth metal neodecanoate chosen from the group consisting of: yttrium neodecanoate, erbium neodecanoate, or neodymium neodecanoate.